# FASCICULE DE BREVET EUROPEEN

(11) **EP 2 131 636 B1**
(45) Date de publication et mention de la délivrance du brevet: **29.02.2012**
(21) Numéro de dépôt: 09161333.1
(22) Date de dépôt: 28.05.2009
(51) Int. Cl.: H05K 3/34, B23K 3/06

(54) **Dispositif de brasage comportant un creuset avec surface réalisée en un matériau neutre par rapport à un métal d'apport pour le brasage**
Lötvorrichtung mit einem Tiegel, der über eine Oberfläche aus neutralem Material gegenüber dem Aufbringungsmetall für das Löten verfügt
Brazing device comprising a crucible with a surface made from a neutral material in relation to a filling metal for brazing

(30) Priorité: 02.06.2008 FR 0803074
(43) Date de publication de la demande: 09.12.2009
(73) Titulaire: Robert Bosch GmbH, 70442 Stuttgart (DE)
(72) Inventeur: Faudemer, Daniel, 14260 Aunay sur Audon (FR); Abouassam, Aïcha, 14000 Caen (FR); Leinenbach, Patrick, 14125 Mondeville (FR)
(74) Mandataire: Hurwic, Aleksander Wiktor

(56) Documents cités:
- DE-A1- 4 133 224
- DE-A1- 4 425 260
- US-A- 3 398 873
- US-A- 5 860 582
- US-A1- 2006 054 658

## Description

L'invention se rapporte à un creuset pour un dispositif de brasage de composants électroniques sur une carte à circuit imprimé.

L'invention se rapporte plus particulièrement à un creuset pour un dispositif de brasage d'au moins une patte de composant électronique sur une carte à circuit imprimé, qui est destiné à contenir un métal d'apport en fusion chauffé à une température de brasage déterminée.

On connaît déjà des creusets de ce type (cf DE 4133224, DE 4425260, US2006/0054658 et US3398873). Ce type de creuset est notamment utilisé dans des dispositifs automatiques de brasage en grande série de pattes de composants électroniques sur des cartes à circuit imprimé.

Le brasage des composants électroniques sur des cartes à circuit imprimé est réalisé avec un métal d'apport en fusion qui est chauffé à une température de brasage inférieure à 450°C, par exemple entre 310°C et 325°C. Ce type de brasage est aussi appelé "brasage tendre" ou "soldering" en langue anglaise.

Il est connu de réaliser un tel creuset en acier. Le métal d'apport en fusion est généralement constitué d'un alliage comportant de l'étain (Sn). Le métal d'apport en fusion est contenu dans le creuset directement au contact de sa face concave intérieure en acier et des faces extérieures supérieure et latérales en acier.

Pour la suite de ce brevet, les faces intérieure et extérieures du creuset seront désignées par le terme "surface".

L'état de la surface du creuset doit être suffisamment soigné pour présenter une mouillabilité par rapport au métal d'apport en fusion qui soit adaptée aux opérations de brasage. La surface, c'est-à-dire la face intérieure et les faces extérieures du creuset, doit notamment présenter une très faible rugosité.

Si la mouillabilité de la surface du creuset est insuffisante, la brasure obtenue à la fin de l'opération de brasage risque d'être défectueuse.

Or, on a constaté qu'à la température de brasage, l'étain (Sn) entrant dans la composition de l'alliage métallique d'apport réagit avec le fer de l'acier formant la surface du creuset. Il se forme alors une couche superficielle rugueuse de composé intermétallique d'étain (Sn) et de fer (FeₓSn_{y}) qui recouvre la surface du creuset. Lorsque cette couche rugueuse est trop épaisse, la mouillabilité de la surface du creuset est dégradée, affectant ainsi la qualité des brasures réalisées. Or, l'épaisseur de cette couche intermétallique croît très rapidement. Par exemple, en moins de quatre heures d'utilisation, la mouillabilité de la surface du creuset est trop dégradée pour permettre la réalisation de brasures solides.

Pour résoudre ce problème, il est connu d'interrompre régulièrement le dispositif de brasage pour effectuer une opération de nettoyage du creuset en ôtant la couche superficielle rugueuse.

Cependant, cette solution est très onéreuse car elle nécessite d'arrêter fréquemment le dispositif de brasage, par exemple toutes les quatre heures.

De plus, le dispositif de brasage est immobilisé le temps de l'opération de nettoyage. Or, cette opération de nettoyage est d'une durée élevée, par exemple un quart d'heure.

Pour résoudre notamment ces problèmes, l'invention propose un creuset réalisé comme décrit précédemment, caractérisé en ce que la surface du creuset est réalisée en un matériau neutre qui ne réagit pas ou sensiblement pas avec le métal d'apport de manière à éviter la formation d'une couche superficielle de composé intermétallique sur la surface du creuset.

Selon d'autres caractéristiques de l'invention :
- la surface du creuset est portée par un revêtement rapporté ;
- creuset est destiné à contenir un métal d'apport qui est constitué par un alliage qui comporte de l'étain ;
- creuset est destiné à contenir un métal d'apport qui est constitué par un alliage d'étain et de plomb ;
- le métal d'apport est constitué par un alliage d'étain, de cuivre et d'argent ;
- le revêtement est réalisé en nitrure de titane ;
- le revêtement est réalisé en zinc ;
- le revêtement est réalisé en iridium ;
- le revêtement est réalisé en céramique.

L'invention concerne aussi un dispositif automatique de brasage en série d'au moins une patte d'au moins un composant électronique sur des cartes à circuit imprimé, caractérisé en ce qu'il comporte au moins un creuset réalisé selon, les enseignements de l'invention. L'invention a pour objet un dispositif automatique de brasage tel que revendiqué dans les revendication.

D'autres caractéristiques et avantages apparaîtront au cours de la lecture de la description détaillée qui va suivre pour la compréhension de laquelle on se reportera aux figures annexées parmi lesquelles :
- la figure 1 est une vue schématique en coupe verticale qui représente un dispositif automatique de brasage en grande série de composants électroniques sur des cartes à circuit imprimé entre deux opérations de brasage ;
- la figure 2 est une vue similaire à celle de la figure 1 qui représente le dispositif automatique de brasage lors d'une opération de brasage ;
- la figure 3 est une vue en coupe verticale qui représente le creuset comportant un revêtement réalisé selon les enseignements de l'invention ;
- la figure 4 est une vue similaire à celle de la figure 3 qui représente un creuset du dispositif automatique de brasage juste avant une opération de brasage ;
- la figure 5 est une vue similaire à celle de la figure 3 qui représente le creuset lors de l'opération de brasage.

Pour la suite de la description, des éléments identiques, analogues ou similaires seront désignés par des mêmes numéros de référence.

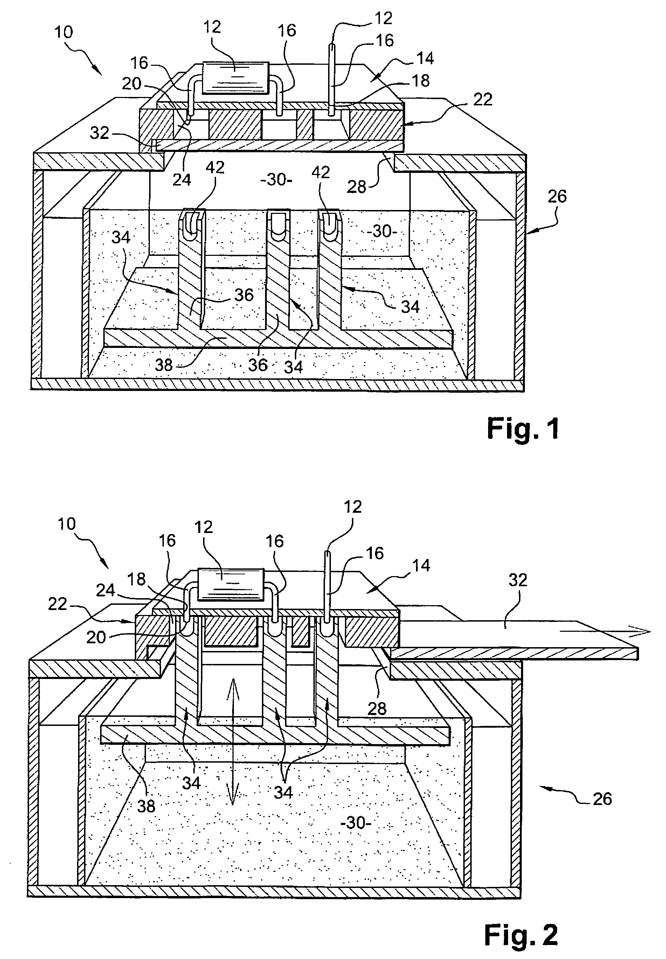

On a représenté à la figure 1 un dispositif 10 automatique de brasage en grande série de composants électroniques 12 sur des cartes horizontales à circuit imprimé 14, dont une seule est représentée.

Chaque composant électronique 12 comporte au moins une patte 16 verticale métallique de fixation sur la carte à circuit imprimé 14. La patte 16 métallique de fixation est aussi destinée à former aussi un contact électrique avec le circuit imprimé.

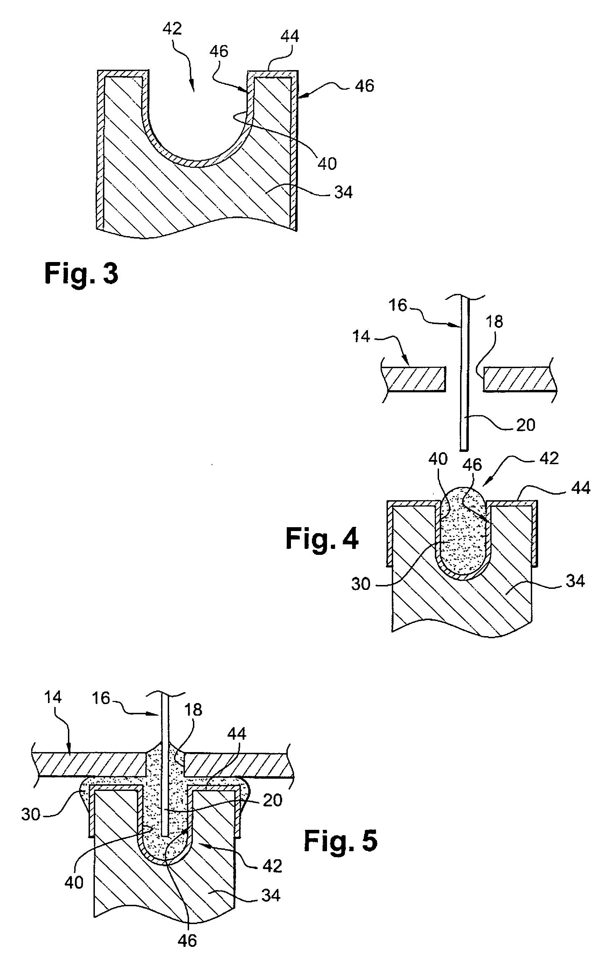

Chaque patte 16 est introduite dans un orifice 18 traversant de fixation correspondant réalisé dans la carte à circuit imprimé 14, comme représenté plus en détail à la figure 4. Ainsi, lorsque les composants électroniques 12 sont positionnés sur la carte à circuit imprimé 14, un tronçon d'extrémité inférieure libre 20 des pattes 16 dépasse sous la carte à circuit imprimé 14.

Comme représenté à la figure 1, la carte à circuit imprimé 14 sur laquelle les composants électroniques 12 sont positionnés est posée sur un support 22 supérieur horizontal du dispositif 10 de brasage comportant des jours 24 qui sont agencés en coïncidence avec les pattes 16 de fixation.

Le dispositif 10 de brasage comporte aussi un bac 26 inférieur qui comporte une ouverture 28 supérieure qui est agencée au-dessous et au droit du support 22. Le bac 26 contient un bain de métal d'apport 30 en fusion.

Le métal d'apport 30 est plus particulièrement constitué d'un alliage métallique sensiblement eutectique d'étain (Sn) et de plomb (Pb), comportant par exemple 63% d'étain (Sn) et 37% de plomb (Pb).

Selon une variante non représentée de l'invention, le métal d'apport 30 est constitué par un alliage d'étain (Sn), de cuivre (Cu) et d'argent (Ag).

Le bac 26 comporte des moyens de chauffage (non représentés) du bain à une température de brasage qui est supérieure à la température de fusion du métal d'apport 30, qui est ici de 183°C. La température de brasage est par exemple comprise entre 300°C et 350°C. De préférence, la température de brasage est comprise entre 310°C et 325°C.

L'ouverture 28 du bac 26 est susceptible d'être fermée par une plaque 32 horizontale qui est montée coulissante transversalement entre une position ouverte dans laquelle l'ouverture 28 débouche directement sous le support 22 et une position fermée dans laquelle le bac 26 est clos. La plaque 32 est plus particulièrement interposée entre le bac 26 et le support 22.

Le bac 26 est clos entre deux opérations de brasage de manière à empêcher l'oxydation du métal d'apport 30 à la surface du bain. A cet effet, lorsque le bac 26 est clos, la surface du bain est généralement exposée à un gaz non réactif tel que de l'azote.

Une pluralité de colonnes 34 verticales sont agencées dans le bac 26. La base 36 de chaque colonne 34 est fixée sur un plateau 38 horizontal inférieur commun. Chaque colonne 34 comporte une face d'extrémité supérieure concave qui forme la face intérieure 40 d'un creuset 42.

Chaque creuset 42 est agencé en correspondance avec un jour 24 associé du support 22. Les jours 24 sont dimensionnés de manière à permettre le passage des creusets 42 en direction de la carte à circuit imprimé 14 comme on le verra par la suite.

Pour la suite de la description, on ne décrira qu'un seul creuset 42. Sa description sera applicable aux autres creusets 42.

Le creuset 42 est délimité radialement par une face périphérique 44 supérieur. La face périphérique 44 comporte au moins un créneau (non représenté) pour l'évacuation du surplus de métal d'apport 30 en fusion lors de l'opération de brasage.

Par la suite, l'ensemble formé par la face intérieure 40, la face périphérique 44 ainsi qu'une portion d'extrémité supérieure des faces latérales de chaque colonne 34 sera désigné par le terme "surface" 40, 44.

Le plateau 38 forme un ascenseur qui est monté mobile verticalement dans le bac 26. Les creusets 42 sont ainsi montés mobiles entre une position basse d'immersion dans laquelle les creusets 42 sont entièrement immergés dans le bain de métal d'apport 30 en fusion comme représenté à la figure 1, et une position haute émergée de brasage dans laquelle les creusets 42 sont introduits dans les jours 24 du support 22 de manière que le tronçon d'extrémité inférieure libre 20 de chaque patte 16 soit plongé dans le creuset 42 associé, comme représenté aux figures 2 et 5.

Ainsi, lorsque les creusets 42 remontent vers leur position supérieure de brasage, ils sont remplis à ras bord de métal d'apport 30 en fusion.

Les colonnes 34 sont généralement réalisées en acier. Pour éviter que le fer entrant dans la composition de l'acier formant la surface 40, 44 du creuset 42 ne réagisse avec l'un des composants métalliques entrant dans la composition du métal d'apport 30, l'invention propose de réaliser la face intérieure 40 du creuset 42 en un matériau neutre qui ne réagit pas du tout ou sensiblement pas avec le métal d'apport 30 à la température de brasage de manière à éviter la formation d'une couche superficielle de composé intermétallique sur la face intérieure 40 du creuset 42.

De plus, le matériau neutre est sélectionné de manière que sa température de fusion soit supérieure à la température de brasage.

En outre, le matériau neutre est suffisamment dur pour éviter l'usure thermique.

La surface 40, 44 du creuset 42 réalisée en matériau neutre doit présenter une mouillabilité adaptée à l'opération de brasage, et la mouillabilité doit notamment être suffisante pour que le métal d'apport 30 en fusion présente une surface supérieure convexe comme représenté à la figure 4.

Plus particulièrement, comme représenté à la figure 3, les colonnes 34 sont réalisées en acier, et la surface 40, 44 du creuset 42 est portée par un revêtement 46 réalisé en ledit matériau neutre. Dans le mode de réalisation représentés aux dessins, le revêtement 46 est rapporté et il s'étend au moins en partie sur les faces latérales verticales des colonnes 34.

Selon un premier mode de réalisation, le revêtement 46 du creuset 42 est réalisé en nitrure de titane (TiN). En effet, le titane (Ti) est neutre vis-à-vis du plomb (Pb), c'est-à-dire que le titane (Ti) ne réagit pas du tout avec le plomb (Pb) à la température de brasage.

Le titane (Ti) est sensiblement neutre vis-à-vis de l'étain (Sn), c'est-à-dire qu'il ne réagit sensiblement pas avec l'étain (Sn) à la température de brasage.

Par "ne réagit sensiblement pas" avec l'étain (Sn), on comprendra que, à la température de brasage, la formation d'une couche de composé intermétallique composée de titane (Ti) et d'étain (Sn) est beaucoup plus lente que la formation d'une couche de composé intermétallique composée de fer (Fe) et d'étain (Sn). Ainsi, les creusets 42 ne nécessiteraient par exemple qu'une opération de nettoyage pour 24 heures d'utilisation au lieu d'une toutes les quatre heures.

De même, dans le cas où le métal d'apport 30 est constitué d'un alliage d'étain (Sn), de cuivre (Cu) et d'argent (Ag), le titane (Ti) est neutre vis-à-vis du cuivre (Cu), et de l'argent (Ag), c'est-à-dire que le titane (Ti) ne réagit pas du tout ni avec le cuivre (Cu), ni avec l'argent (Ag).

Ainsi, à la température de brasage, le titane (Ti) est totalement neutre vis-à-vis du cuivre (Cu), de l'argent (Ag) et du plomb (Pb), et sensiblement neutre vis-à-vis de l'étain (Sn).

Selon un deuxième mode de réalisation, le revêtement 46 du creuset 42 est réalisé en zinc (Zn).

En effet, à la température de brasage, le zinc (Zn) est totalement neutre vis-à-vis de l'étain (Sn) et du plomb (Pb), c'est-à-dire que le zinc (Zn) ne réagit pas du tout ni avec l'étain (Sn), ni avec le plomb (Pb). Ainsi, les creusets 42 ne nécessitent pas d'opération de nettoyage car il ne se forme aucune couche de composé intermétallique.

De même, dans le cas où le métal d'apport 30 est constitué d'un alliage d'étain (Sn), de cuivre (Cu) et d'argent (Ag), le zinc (Zn) ne réagit pas du tout, à la température de brasage, ni avec le cuivre (Cu), ni avec l'argent (Ag).

Ainsi, à la température de brasage, le zinc (Zn) est totalement neutre vis-à-vis de l'étain (Sn), du plomb (Pb), du cuivre (Cu) et de l'argent (Ag).

Selon encore un troisième mode de réalisation de l'invention, le revêtement 46 est réalisé en iridium (Ir).

L'iridium (Ir) présente en effet des propriétés de neutralité similaires à celles du zinc (Zn) vis-à-vis de l'étain (Sn), du plomb (Pb), du cuivre (Cu) et de l'argent (Ag) à la température de brasage.

Selon un quatrième mode de réalisation de l'invention, le revêtement 46 du creuset 42 est réalisé en un matériau céramique présentant des propriétés similaires à celles décrites pour le zinc (Zn).

Lors du fonctionnement du dispositif 10 de brasage comportant un tel creuset 42, la carte à circuit imprimé 14 sur laquelle les composants électroniques 12 sont positionnés, est agencée sur le support 22, comme représenté à la figure 1.

Puis, un flux de brasage est appliqué sur les éléments à braser, en particulier sur la patte 16 de fixation et sur le pourtour de l'orifice de fixation 18 de la patte 16.

Un flux de brasage est un mélange de produits chimiques permettant d'assurer un bon mouillage du métal d'apport 30 sur les pièces à assembler en éliminant les oxydes présents à la surface des pièces à assembler, en protégeant les pièces à assembler de l'oxydation pendant toute la durée de l'opération de brasage, et en baissant la tension superficielle du métal d'apport 30 en fusion.

Puis, la plaque 32 est commandée vers sa position ouverte, et les creusets 42 sont remontés vers leur position haute émergée de brasage, comme illustré à la figure 2.

Comme représenté à la figure 4, le revêtement 46 du creuset 42 présente une mouillabilité telle que la surface supérieure libre du métal d'apport 30 en fusion contenu dans le creuset 42 soit convexe. Ainsi, la partie convexe du métal d'apport 30 en fusion est située au-dessus du niveau de la face périphérique 44 du creuset 42.

Comme représenté à la figure 5, lorsque les creusets 42 sont en position haute émergée de brasage, le tronçon d'extrémité inférieure libre 20 de chaque patte 16 est plongé dans le creuset 42 associé. La métal d'apport 30 en fusion contenu dans le creuset 42 remonte par capillarité dans l'orifice de fixation 18 de la carte à circuit imprimé 14 le long de la patte 16 de fixation de manière à obturer totalement l'orifice de fixation 18, mais sans se répandre sur la face supérieure de la carte à circuit imprimé 14.

Une partie du surplus du métal d'apport 30 en fusion est évacuée par les créneaux réalisés dans la face périphérique 44 du creuset 42.

Les matériaux décrits précédemment pour réaliser le revêtement 46 du creuset 42 présentent des propriétés de mouillage adaptées à une telle opération de brasage. Ainsi, la tension superficielle du métal d'apport 30 contenu dans le creuset 42 est ni trop faible, de manière que la surface libre soit bombée ou convexe, ni trop élevée de manière que le métal d'apport 30 ne se répande pas sur la face supérieure de la carte à circuit imprimé 14 lors de l'opération de brasage.

De plus, ces matériaux permettent d'éviter totalement ou au moins de ralentir énormément, la formation d'une couche superficielle de composé intermétallique dans le creuset 42. Le dispositif 10 de brasage en grande série peut donc fonctionner sans les interruptions dues aux opérations de nettoyage des creusets 42.

## Revendications

1. Dispositif (10) automatique de brasage en série d'au moins une patte (16) d'au moins un composant électronique (12) sur des cartes à circuit imprimé (14) comportant un bac (26) de réception d'un métal d'apport (30), des moyens de chauffage, un plateau sur lequel est fixée une plurallité de colonnes (34) verticales, chaque colonne (34) comporte une face d'extrémité supérieure concave qui forme la face inférieure (40) d'un creuset (42)
**caractérisé en ce que** la surface (40, 44) d'au moins un creuset (42) est réalisée en un matériau neutre qui ne réagit pas ou sensiblement pas avec le métal d'apport (30) de manière à éviter la formation d'une couche superficielle de composé intermétallique sur la surface (40, 44) du creuset (42).

2. **Dispositif (10)** selon la revendication précédente, **caractérisé en ce que** la surface (40, 44) du creuset (42) est portée par un revêtement (46) rapporté.

3. **Dispositif (10)** selon la revendication précédente, **caractérisé en ce que** le creuset (42) est destiné à contenir un métal d'apport (30) qui est constitué par un alliage qui comporte de l'étain (Sn).

4. **Dispositif (10)** selon l'une quelconque des revendications précédentes, **caractérisé en ce que** le creuset (42) est destiné à contenir un métal d'apport (30) qui est constitué par un alliage d'étain (Sn) et de plomb (Pb).

5. **Dispositif (10)** selon l'une quelconque des revendications 1 à 3, **caractérisé en ce que** le métal d'apport (30) est constitué par un alliage d'étain (Sn), de cuivre (Cu) et d'argent (Ag).

6. **Dispositif (10)** selon l'une quelconque des revendications 2 à 5, **caractérisé en ce que** le revêtement (46) est réalisé en nitrure de titane (TiN).

7. **Dispositif (10)** selon l'une quelconque des revendications 2 à 5, **caractérisé en ce que** le revêtement (46) est réalisé en zinc (Zn).

8. **Dispositif (10)** selon l'une quelconque des revendications 2 à 5, **caractérisé en ce que** le revêtement (46) est réalisé en iridium (Ir).

9. **Dispositif (10)** selon l'une quelconque des revendications 2 à 5, **caractérisé en ce que** le revêtement (46) est réalisé en céramique.

## Claims

1. Automatic device (10) for soldering, in series, at least one pin (16) of at least one electronic component (12) to printed circuit boards (14), the device comprising a tray (26) for receiving a solder (30), heating means and a plate to which is fastened a plurality of vertical columns (34), each column (34) comprising a concave top end face that forms the inner face (40) of a pot (42),
**characterized in that** the surface (40, 44) of at least one pot (42) is made of an inert material that does not react or does not react substantially with the solder (30) in order to prevent a superficial layer of intermetallic compound from forming on the surface (40, 44) of the pot (42).

2. Device (10) according to the preceding claim, **characterized in that** the surface (40, 44) of the pot (42) is borne by an attached coating (46).

3. Device (10) according to the preceding claim, **characterized in that** the pot (42) is intended to contain a solder (30) that consists of an alloy comprising tin (Sn).

4. Device (10) according to any one of the preceding claims, **characterized in that** the pot (42) is intended to contain a solder (30) that consists of a tin (Sn)-lead(Pb) alloy.

5. Device (10) according to any one of Claims 1 to 3, **characterized in that** the solder (30) consists of a tin (Sn)-copper (Cu)-silver (Ag) alloy.

6. Device (10) according to any one of Claims 2 to 5, **characterized in that** the coating (46) is made of titanium nitride (TiN).

7. Device (10) according to any one of Claims 2 to 5, **characterized in that** the coating (46) is made of zinc (Zn).

8. Device (10) according to any one of Claims 2 to 5, **characterized in that** the coating (46) is made of iridium (Ir).

9. Device (10) according to any one of Claims 2 to 5, **characterized in that** the coating (46) is made of a ceramic.

## Patentansprüche

1. Automatische Vorrichtung (10) zum Serienlöten mindestens einer Lasche (16) mindestens eines elektronischen Bauteils (12) auf gedruckte Leiterplatten (14), die einen Aufnahmebehälter (26) eines Lots (30), Heizeinrichtungen und eine Platte aufweist, auf der eine Vielzahl von senkrechten Säulen (34) befestigt ist, wobei jede Säule (34) eine obere konkave Endseite aufweist, die die Innenseite (40) eines Tiegels (42) bildet,
**dadurch gekennzeichnet, dass** die Fläche (40, 44) mindestens eines Tiegels (42) aus einem neutralen Material hergestellt ist, das nicht oder im Wesentlichen nicht mit dem Lot (30) reagiert, um die Bildung einer Oberflächenschicht einer intermetallischen Verbindung auf der Fläche (40, 44) des Tiegels (42) zu verhindern.

2. Vorrichtung (10) nach dem vorhergehenden Anspruch, **dadurch gekennzeichnet, dass** die Fläche (40, 44) des Tiegels (42) von einer angefügten Beschichtung (46) getragen wird.

3. Vorrichtung (10) nach dem vorhergehenden Anspruch, **dadurch gekennzeichnet, dass** der Tiegel (42) dazu bestimmt ist, ein Lot (30) zu enthalten, das aus einer Zinn (Sn) enthaltenden Legierung besteht.

4. Vorrichtung (10) nach einem der vorhergehenden Ansprüche, **dadurch gekennzeichnet, dass** der Tiegel (42) dazu bestimmt ist, ein Lot (30) zu enthalten, das aus einer Legierung aus Zinn (Sn) und Blei (Pb) besteht.

5. Vorrichtung (10) nach einem der Ansprüche 1 bis 3, **dadurch gekennzeichnet, dass** das Lot (30) aus einer Legierung aus Zinn (Sn), Kupfer (Cu) und Silber (Ag) besteht.

6. Vorrichtung (10) nach einem der Ansprüche 2 bis 5, **dadurch gekennzeichnet, dass** die Beschichtung (46) aus Titaniumnitrid (TiN) hergestellt ist.

7. Vorrichtung (10) nach einem der Ansprüche 2 bis 5, **dadurch gekennzeichnet, dass** die Beschichtung (46) aus Zink (Zn) hergestellt ist.

8. Vorrichtung (10) nach einem der Ansprüche 2 bis 5, **dadurch gekennzeichnet, dass** die Beschichtung (46) aus Iridium (Ir) hergestellt ist.

9. Vorrichtung (10) nach einem der Ansprüche 2 bis 5, **dadurch gekennzeichnet, dass** die Beschichtung (46) aus Keramikmaterial hergestellt ist.
